Europäisches Patentamt

European Patent Office

Office européen des brevets

(19)

(11) Veröffentlichungsnummer: **0 048 313**
**B1**

(12) # EUROPÄISCHE PATENTSCHRIFT

(45) Veröffentlichungstag der Patentschrift:
09.10.85

(21) Anmeldenummer: 81102355.5

(22) Anmeldetag: 28.03.81

(51) Int. Cl.⁴: **H 01 L 39/12, H 01 L 39/24, C 22 C 9/02, C 22 C 27/02**

(54) **Supraleitende Drähte auf der Basis von Bronze-Nb3Sn und Verfahren zu deren Herstellung.**

(30) Priorität: 18.09.80 DE 3035220

(43) Veröffentlichungstag der Anmeldung:
31.03.82 Patentblatt 82/13

(45) Bekanntmachung des Hinweises auf die Patenterteilung: 09.10.85 Patentblatt 85/41

(84) Benannte Vertragsstaaten:
DE FR GB

(56) Entgegenhaltungen:
EP-A- 0 032 691
CH-A- 413 019
DE-B- 2 339 050
GB-A- 1 394 724
JP-A-55 039 144
US-A- 3 346 425
US-A- 3 481 800
US-A- 3 484 208
US-A- 3 525 150
US-A- 3 541 680
US-A- 3 838 503
US-A- 4 224 087
JOURNAL OF APPLIED PHYSICS, Vol. 49, No. 1, Jänner 1978, American Institute of Physics D. DEW-HUGHES U.M. SUERAGA "Critical-current densities of bronze-processed Nb3(Sn1-xGax) wires up to 23,5T" Seiten 357-360
IEEE TRANSACTIONS ON MAGNETICS, Vol. MAG-14, No. 5, September 1978, The IEEE Magnetics Society J.D. LIVINGSTON "Effect of Ta-Additions to Bronze-processed Nb3 Sn Superconductors" Seiten 611-613
Handbook of Chemistry and Physics, 51st Ed., 1970/71, S.E-100

(73) Patentinhaber: Kernforschungszentrum Karlsruhe GmbH
Weberstrasse 5
D-7500 Karlsruhe 1 (DE)

(72) Erfinder: Flükiger, René, Dr. Dipl.-Phys.
Schneidemühlstrasse 6 E
D-7500 Karlsruhe (DE)

## Beschreibung

Die Erfindung betrifft supraleitende Drähte auf der Basis von Bronze-$Nb_3Sn$, die bei hohen Magnetfeld-Werten anwendbar sind.

$Nb_3Sn$-Supraleiterdrähte mit hohen kritischen Stromdichten werden heute kommerziell nach der sogenannten Bronze-Methode hergestellt. Zwei andere Verfahren, die « in situ » Methode und die pulvermetallurgische Methode stehen kurz vor der industriellen Reife. Alle drei Verfahren erstellen Produkte mit vergleichbaren kritischen Stromstärken, die Produkte der zwei letzteren aber zeichnen sich durch bessere mechanische Eigenschaften aus, die auf die dünneren $Nb_3Sn$-Filamente mit Durchmesser von 0,1 bis 0,5 μm gegenüber 3-5 μm bei der Bronze-Methode zurückgeführt werden. Das Verhalten der kritischen Stromstärken, $J_c$ unter Anwendung einer Zugspannung zeigt bei $Nb_3Sn$-Vielkernsupraleiterdrähten zunächst einen Anstieg bis $J_{cmax}$, nimmt dann ab bis zu Werten, die unterhalb $J_{co}$, dem Anfangswert, liegen, worauf der Draht in der Regel abreißt. Dieses Verhalten ist von Rupp auf die unterschiedliche Kontraktion der $Nb_3Sn$-Filamente und der Bronze-Matrix beim Abkühlen bis 4,2 K zurückgeführt worden. Nach diesem sogenannten « Prestress-Modell » stehen die $Nb_3Sn$-Filamente zunächst unter longitudinalem und radialem Druck, der durch die Anwandung einer Zugkraft allmählich abgebaut wird. Bei Erreichen von $j_{cmax}$ entsprechend einer Dehnung $\varepsilon_m$, ist der « Prestress » gerade kompensiert. Bei einer weiteren Erhöhung der Zugspannung werden die Filamente aufgrund des größeren Elastizitätsmoduls gegenüber der Bronze dann auf Zug beansprucht, was zunächst einer Erniedrigung von $j_c$ und später das Reißen der Filamente zur Folge hat. In diesem einfachen Modell ist $j_{cmax}$ die kritische Stromdichte des nahzu oder vollständig entspannten Leiters, wogegen $j_{co}$ durch die Kontraktion heruntergedrückt wird.

Der Quotient $j_{cmax}/j_{co}$ ist stark magnetfeldabhängig ; unabhängig von der Art des Supraleiters ist er am größten für die höchsten Magnetfelder $B_o$. Bei $Nb_3Sn$-Supraleitern ist dieser Quotient viel größer als beispielsweise bei $V_3Ga$, $Nb_3Al$ oder den Lavesphasen $(Zr,Hf)V_2$. Bei 12 T variiert dieser Quotient bei $Nb_3Sn$ zwischen 1,2 und 2. Bei 16 T sind schon Werte bis zu $j_{cmax}/j_{co} = 6$ gemessen worden.

Kürzlich ist es unter anderem Luhman et al, ICMC Conference, Madison, Wi, August 1979, gelungen, durch Zulegierung von Ta zum Nb den $j_c$-Wert von $Nb_3Sn$ drastisch zu erhöhen. Sekine et al, Applied Physical Letters 35, 472 (1979), kamen zu ähnlichen Verbesserungen durch Zulegierung von Hf zum Nb und Ga zur Bronze.

Aus der US-Patentschrift 4,224,087 ist ein verbessertes Verfahren zur Herstellung von Supraleitern aus einem Kern aus Niob und einer diesen Kern umgebenden Schicht aus einer Cu-Sn-Legierung bekannt geworden, bei welchem durch Ziehen und Wärmebehandeln eine Zwischenschicht (zwischen dem Nb und der Cu-Sn-Legierung) aus $Nb_3Sn$ gebildet wird, das vorschlägt, daß die Cu-Sn-Legierung 1 bis 20 Atom-% Sn enthalten soll und das Nb-Metall aus einer Nb-Hf-Legierung mit 0,1 bis 30 Atom-% Hf bestehen soll. Die Cu-Sn-Legierung kann auch wenigstens ein Metall aus der Gruppe 0,1 bis 15 Atom-% Ga und 0,1 bis 10 Atom-% Al enthalten. Diese Zusätze sollen die Werte für den kritischen Strom gegenüber den Werten von Supraleitern aus einer Cu-Sn-Zn-Legierung und Nb oder einer Nb-Legierung mit geringen Mengen Zr, Hf oder Ti erhöhen. Die Auswirkungen eines « Prestresses » und wie dieser reduziert bzw. kompensiert werden kann, wird in dieser Druckschrift nicht angesprochen.

Kürzlich wurden $(NbTa)_3Sn$-Drähte auch mittels der « in situ »-Technik (R. Flükiger, ICMC Conference, Mai 1980, Brookhaven, USA) hergestellt, was auch zu erhöhten $j_c$-Werten gegenüber denen des binären $Nb_3Sn$ führte.

Wenig ist über die mechanischen Eigenschaften von diesen Legierungen bekannt.

Nur im letzten Fall ist die Abhängigkeit von $j_c$ als Funktion der Zugspannung bis zu hohen Feldern gemessen worden. Luhman et al haben im Falle von Ta-Zusätzen die mechanischen Eigenschaften bis zu 6 T gemessen ; dieses Feld ist aber zu niedrig, um Rückschlüsse auf das Verhalten bei hohen Feldern geben zu können. Kürzlich haben Scanlan et al, ICMC, May 1980, Brookhaven, USA, den Einfluß der Zugspannung auf ein $Nb_3Sn$-Kabel gemessen ; in einem Fall war dieses Kabel von einem Kupfermantel, im anderen von einer Hülle aus rostfreiem Stahl umgeben. Im zweiten Fall wurde ein merklich kleineres $j_{co}$ beobachtet ; die starre Stahlstruktur verstärkt den « Prestress-Effekt ».Die Aufgabenstellung bei den $Nb_3Sn$-Drähten war bisher immer mit der Erreichung von noch höheren $j_c$-Werten verbunden.

Der Erfindung liegt dagegen die Aufgabe zugrunde, Drähte für die Herstellung von Vielkernsupraleiterdrähten auf der Basis von Bronze-$Nb_3Sn$ bereitzustellen, die frei bzw. nahezu frei sind von der vor allem bei hohen Magnetfeldern auftretenden Eigenschaft (dem sogenannten « Prestress-Effekt ») der bisher hergestellten Bronze-$Nb_3Sn$-Drähte, nämlich die (ohne Anwendung einer dem radialen und longitudinalen Druck der Bronze-Umhüllung auf die supraleitenden Filamente entgegenwirkenden Zugspannung) entsprechende kritische Stromstärke zu niedrigeren Werten zu verschieben im Vergleich zu dem maximalen Wert der kritischen Stromstärke $(j_{cmax})$, bei welchem der Radial- und Longitudinal-Quotient $j_{cmax}/j_{co}$ möglichst nahe eins ist (wobei $j_{co}$ die kritische Stromstärke des s. l. Drahtes unter « prestress » ohne Zugspannung bedeutet). Außerdem sollen in Verbindung mit den bereitzustellenden « prestress » ohne Zugspannung bedeutet) Außerdem sollen in Verbindung mit den bereitzustellenden Drähten starre Stützstrukturen (beispielsweise aus Stahl, Cu-Mo oder Cu-Be etc.) oder härtere Bronzen (mit beispielsweise Be- oder Si-Zusätzen etc.) angewendet werden können, ohne daß eine wesentliche Erniedrigung von $j_c$ eintritt.

Die Aufgabe wird durch die erfindungsgemäßen supraleitenden Drähte gelöst, die gekennzeichnet sind durch

a) wenigstens ein Legierungselement aus der Gruppe ferromagnetischer Elemente Eisen und Nickel, zulegiert zumindest zu einer der beiden Komponenten,

b) wenigstens ein Legierungselement aus der Gruppe I Li, Sc, U, Ti, Zr, Hf, V, Ta, Mo, Re, Ru, Pd, Zn, Al, Ga, In, Tl, Si, Ge, Sb, zulegiert zumindest zu einer der beiden Komponenten,

c) im Falle der Zulegierung zur Nb-Komponente durch den Gesamtbetrag der Legierungselemente aus a) und b) im Gewichtsprozent-Bereich zwischen 0,01 und 7, bezogen auf den Nb-Anteil im Draht und/oder

d) im Falle der Zulegierung zur Bronze-Komponente durch den Gesamtbetrag der Legierungselemente aus a) und b) im Gewichtsprozent-Bereich zwischen 0,05 und 10, bezogen auf den Bronze-Anteil im Draht.

Eine besonders vorteilhafte Ausbildung der Erfindung ist gekennzeichnet durch Zulegierungs-Kombinationen zur Nb-Komponente aus wenigstens einem ferromagnetischen Element aus Fe und Ni, wobei Fe im Bereich 0,05 Gew.-% bis 0,5 Gew.-% und Ni im Bereich 0,1 Gew.-% bis 0,5 Gew.-%, bezogen auf den Nb-Anteil im Draht, verwendet wird, und aus wenigstens einem Element der nachfolgenden Gruppe II in den angegebenen Bereichen

Ti 1 bis 5 Gew.-%          Mo 0,1 bis 0,5 Gew.-%
Zr 1 bis 5 Gew.-%          Re 0,1 bis 2 Gew.-%
Hf 1 bis 5 Gew.-%          Ru 0,1 bis 3 Gew.-%
V 1 bis 5 Gew.-%           Sc 0,01 bis 0,2 Gew.-%
Ta 1 bis 7 Gew.-%          Si 0,1 bis 1,5 Gew.-%
Pd 0,1 bis 2 Gew.-%
U 1 bis 5 Gew.-%

bezogen auf den Niob-Anteil im Draht und/oder durch Zulegierungen zur Cu- oder Bronze-Komponente aus mindestens einem Element aus der nachfolgenden Gruppe in den angegebenen Bereichen.

Zn 0,1 bis 10 Gew.-%       Li 0,1 bis 1 Gew.-%
Al 0,1 bis 3 Gew.-%        In 0,1 bis 5 Gew.-%
Ga 0,1 bis 10 Gew.-%       Tl 0,05 bis 1 Gew.-%
Si 0,1 bis 3 Gew.-%        Sb 0,1 bis 5 Gew.-%
Ge 0,1 bis 0,5 Gew.-%

bezogen auf den Cu- oder Bronze-Anteil im Draht.

Das Verfahren zur Herstellung der erfindungsgemäßen supraleitenden Drähte auf der Basis der Bronze-Technik, der Cu-Matrix-Technik, der « in situ » Technik oder der pulvermetallurgischen Methode ist dadurch gekennzeichnet, daß zur Stabilisierung der kubischen Phase im Bronze-$Nb_3$Sn-Draht und zur weitgehenden Verhinderung einer Bildung der tetragonalen Phase und/oder zur Reduktion der tetragonalen Deformation derselben bei tiefen Temperaturen, selbst bei hohen Magnetfeld-Werten, zu den Niob-Drähten oder zum Niob-Pulver ein Legierungszusatz wenigstens eines ferromagnetischen Elementes aus Fe und Ni im Mengen, entsprechend

Fe 0,05 Gew-% bis 0,5 Gew.-%
Ni 0,1 Gew.-% bis 0,5 Gew.-% und

wenigstens eines Elementes aus der folgenden Gruppe in den Mengen entsprechend

Ti 1 bis 5 Gew-%           Mo 0,1 bis 0,5 Gew.-%
Zr 1 bis 5 Gew-%           Re 0,1 bis 2,0 Gew.-%
Hf 1 bis 5 Gew-%           Ru 0,1 bis 3 Gew.-%
V 1bis 5 Gew.-%            Sc 0,01 bis 0,2 Gew.-%
Ta 1 bis 7 Gew-%           Si 0,1 bis 1,5 Gew.-%
Pd 0,1  bis 2 Gew.-%
U 1 bis 5 Gew.-%

und/oder zum Kupfer- oder Bronze-Anteil ein Legierungszusatz wenigstens eines Elementes der nachfolgenden Gruppe in den Mengen entsprechend

Zn 0,1 bis 10 Gew.-%       Li 0,1 bis 1 Gew.-%
Al 0,1 bis 3 Gew.-%        In 0,1 bis 5 Gew.-%
Ga 0,1 bis 10 Gew.-%       Tl 0,05 bis 1 Gew.-%
Si 0,1 bis 3 Gew.-%        Sb 0,1 bis 5 Gew.-%
Ge 0,1 bis 0,5 Gew.-%

zugegeben wird (werden).

3

Eine andere Weiterbildung des erfindungsgemäßen Verfahrens sieht vor, daß die supraleitenden $Nb_3Sn$-Drähte nach der Reaktion einer Neutronenbestrahlung bei Temperaturen zwischen 4,2 K und 300 K (bis zu $2 \cdot 10^{18}$ n/cm$^2$; E > 1 MeV) zur Stabilisierung der kubischen Phase im Bronze-$Nb_3Sn$-Draht und zur weitgehenden Verhinderung der Bildung der tetragonalen Phase und/oder zur Reduktion der tetragonalen Deformation derselben bei tiefen Temperaturen ausgesetzt werden. Der Legierungszusatz aus der Gruppe zum Cu- oder Bronze-Anteil kann vor dem Erschmelzen bzw. Mischen der Produktbestandteile zugegeben werden, wonach das Schmelzprodukt oder die Mischung in an sich bekannter Weise zu Drähten weiterverarbeitet wird. Mit dem Legierungszusatz aus der Gruppe zum Cu- oder Bronze-Anteil können aber auch vorgefertigte Drähte elektrolytisch, mechanisch oder durch chemische Transportreaktion beschichtet werden bis zu einer Dicke von ca. 15 µm. Der Legierungszusatz aus der Gruppe (II) wird zu der Cu-Nb-Schmelze, zu den Nb-Drähten oder zum Nb-Pulver vor der mechanischen Verarbeitung zugegeben.

Die Erhaltung der kubischen Phase in einem kritischen Feld von 30 T gegenüber 24 T für die tetragonale Phase ist der physikalische Grund dafür, daß

a) $j_c$ wesentlich größer wird,

b) der Quotient $j_{cmax}/j_{co}$ nur noch sehr wenig variiert, aufgrund von Zustandsdichte-Effekten.

Mit der Erfindung ist es erstmals möglich, in kontrollierter Weise den « Prestress-Effekt » in $Nb_3Sn$-Drähten zu umgehen. Durch die Erfindung wird $j_{cmax}$ durch $j_{co}$ klein gehalten im Anwendungsbereich ($\leq$ 0,5 % Dehnung). Gleichzeitig kann nahe an der höchstmöglicher kritischen Stromstärke gearbeitet werden ($j_c$ ist praktisch gleich $j_{cmax}$). Außerdem können starke Stützstrukturen bei der Herstellung der Vielkernsupraleiterdrähte verwendet werden. Die Erfindung ermöglicht sogar die freie Wahl unter solchen Stützstrukturen. Diese können sowohl innerhalb der Drähte als auch als Umhüllung angewendet werden, können aus Stahl, Molybdän, Cu-W, Cu-Be bestehen oder in Form von Si oder Be der Bronze-Matrix zugesetzt werden, ohne daß die Eigenschaften der supraleitenden Phase verschlechtert wird. Außerdem war die Verbesserung der mechanischen Eigenschaften der supraleitenden Drähte als Folge der Stabilisierung der kubischen Phase und/oder der Reduktion des tetragonalen Deformation, die mit der Erfindung erreicht wird, nicht vorhersehbar.

Die Erfindung wird im folgenden anhand von Beispielen erläutert :

1) Durch Zusatz von 1,5 Gew.-% Re zum Nb und 3 Gew.-% Ga zum Kupfer wurden supraleitende Drähte mittels der Cu-Matrix-Methode hergestellt, die bei 20 K keine tetragonale Umwandlung zeigten (keine Aufspaltung der Röntgen-Diffraktionslinien).

2) Durch Zusatz von 3 Gew.-% Ti zum Nb und 3 Gew.-% Ga zum Kupfer wurden supraleitende Drähte mit derselben Eigenschaft hergestellt.

3) Dasselbe wie in Beispiel 1) und 2) mit 3 Gew.-% Hf zum Nb und 4 Gew.-% Zn zum Kupfer

4) Dasselbe wie in den Beispielen 1), 2) und 3), aber mit 3 Gew-% Ta zum Nb und 4 Gew.-% Ga zum Kupfer. An diesem Draht beträgt der Quotient $j_{cmax}/j_{co}$ bei $\varepsilon_{max}$ und 14 T nur 1,4.

5) Supraleitende Bronze-$Nb_3Sn$-Drähte mit 10 Gew.-% Ta-Zusatz wurden mittels « in situ » Technik hergestellt. In einem Fall wurde der Draht in einem Cu-1,8 Gew.-% Be Rohr angeordnet. Die Werte von $j_{co}$ (ohne Anwendung einer Zugkraft) unterschieden sich nur um 4 %, was die erfolgreiche Umgehung des Prestress-Effekt illustriert.

## Patentansprüche

1. Supraleitende Bronze-$Nb_3Sn$-Drähte mit Legierungs-Zusätzen, welche die kubische Phase im Supraleiter stabilisieren, die Bildung einer tetragonalen Phase weitgehend verhindern und/oder die tetragonale Deformation (1-c/a) reduzieren und welche bei hohen Magnetfeld-Werten (> 10 T) anwendbar sind, hergestellt aus einer Niob-Komponente und aus einer Bronze-Komponente, gekennzeichnet durch

a) wenigstens ein Legierungselement aus der Gruppe ferromagnetischer Elemente Eisen und Nickel, zulegiert zumindest zu einer der beiden Komponenten,

b) wenigstens ein Legierungselement aus der Gruppe I Li, Sc, U, Ti, Zr, Hf, V, Ta, Mo, Re, Ru, Pd, Zn, Al, Ga, In, Tl, Si, Ge, Sb, zulegiert zumindest zu einer der beiden Komponenten,

c) im Falle der Zulegierung zur Nb-Komponente durch den Gesamtbetrag der Legierungselemente aus a) und b) im Gewichtsprozent-Bereich zwischen 0,01 und 7, bezogen auf den Nb-Anteil im Draht und/oder

d) im Falle der Zulegierung zur Bronze-Komponente durch den Gesamtbetrag der Legierungselemente aus a) und b) im Gewichtsprozent-Bereich zwischen 0,05 und 10, bezogen auf den Bronze-Anteil im Draht.

2. Supraleitende Drähte gemäß Anspruch 1, gekennzeichnet durch Zulegierungs-Kombinationen zur Nb-Komponente aus wenigstens einem ferromagnetischen Element aus Fe und Ni, wobei Fe im Bereich 0,05 Gew.-% bis 0,5 Gew.-% und Ni im Bereich 0,1 Gew.-% bis 0,5 Gew.-%, bezogen auf den Nb-Anteil im Draht, verwendet wird, und aus wenigstens einem Element der nachfolgenden Gruppe II in den angegebenen Bereichen

Ti 1 bis 5 Gew.-%  
Zr 1 bis 5 Gew.-%  
Hf 1 bis 5 Gew.-%  
V 1 bis 5 Gew.-%  
Ta 1 bis 7 Gew.-%  
Pd 0,1 bis 2 Gew.-%  
U 1 bis 5 Gew.-%  

Mo 0,1 bis 0,5 Gew.-%  
Re 0,1 bis 2 Gew.-%  
Si 0,1 bis 3 Gew.-%  
Sc 0,01 bis 0,2 Gew.-%  
Si 0,1 bis 1,5 Gew.-%  

bezogen auf den Niob-Anteil im Draht und/oder durch Zulegierungen zur Cu- oder Bronze-Komponente aus mindestens einem Element aus der nachfolgenden Gruppe in den angegebenen Bereichen

Zn 0,1 bis 10 Gew.-%  
Al 0,1 bis 3 Gew.-%  
Ga 0,1 bis 10 Gew.-%  
Si 0,1 bis 3 Gew.-%  
Ge 0,1 bis 0,5 Gew.-%  

Li 0,1 bis 1 Gew.-%  
In 0,1 bis 5 Gew.-%  
Tl 0,05 bis 1 Gew.-%  
Sb 0,1 bis 5 Gew.-%  

bezogen auf den Cu- oder Bronze-Anteil im Draht.

3. Verfahren zur Herstellung der in Anspruch 1 genannten supraleitenden Drähte auf der Basis der Bronze-Technik, der Cu-Matrix-Technik, der « in situ »-Technik oder der pulvermetallurgischen Methode, dadurch gekennzeichnet, daß zur Stabilisierung der kubischen Phase im Bronze-$Nb_3Sn$-Draht und zur weitgehenden Verhinderung einer Bildung der tetragonalen Phase und/oder zur Reduktion der tetragonalen Deformation derselben bei tiefen Temperaturen, selbst bei hohen Magnetfeld-Werten, zu den Niob-Drähten oder zum Niob-Pulver ein Legierungszusatz wenigstens eines ferromagnetischen Elementes aus Fe und Ni in Mengen, entsprechend

Fe 0,05 Gew.-% bis 0,5 Gew.-%  
Ni 0,1 Gew.-% bis 0,5 Gew.-% und  

wenigstens eines Elementes aus der folgenden Gruppe in den Mengen entsprechend

Ti 1 bis 5 Gew.-%  
Zr 1 bis 5 Gew.-%  
Hf 1 bis 5 Gew.-%  
V 1 bis 5 Gew.-%  
Ta 1 bis 7 Gew.-%  
Pd 0,1 bis 2 Gew.-%  
U 1 bis 5 Gew.-%  

Mo 0,1 bis 0,5 Gew.-%.  
Re 0,1 bis 2,0 Gew.-%  
Ru 0,1 bis 3 Gew.-%  
Sc 0,01 bis 0,2 Gew.-%  
Si 0,1 bis 1,5 Gew.-%  

und/oder zum Kupfer- oder Bronze-Anteil ein Legierungszusatz wenigstens eines Elementes der nachfolgenden Gruppe in den Mengen entsprechend

Zn 0,1 bis 10 Gew.-%  
Al 0,1 bis 3 Gew.-%  
Ga 0,1 bis 10 Gew.-%  
Si 0,1 bis 3 Gew.-%  
Ge 0,1 bis 0,5 Gew.-%  

Li 0,1 bis 1 Gew.-%  
In 0,1 bis 5 Gew.-%  
Tl 0,05 bis 1 Gew.-%  
Sb 0,1 bis 5 Gew.-%  

zugegeben wird (werden).

4. Verfahren nach Anspruch 3, dadurch gekennzeichnet, daß die supraleitenden $Nb_3$-Sn-Drähte nach der Reaktion einer Neutronenbestrahlung bei Temperaturen zwischen 4,2 K und 300 K (bis zu $2 \cdot 10^{18}$ n/cm² ; E > 1 MeV) zur Stabilisierung der kubischen Phase im Bronze-$Nb_3Sn$-Draht und zur weitgehenden Verhinderung der Bildung der tetragonalen Phase und/oder zur Reduktion der tetragonalen Deformation derselben bei tiefen Temperaturen ausgesetzt werden.

5. Verfahren nach Anspruch 3, dadurch gekennzeichnet, daß der Legierungszusatz aus der Gruppe zum Cu- oder Bronze-Anteil vor dem Erschmelzen bzw. Mischen der Produktbestandteile zugegeben wird und danach das Schmelzprodukt oder die Mischung in an sich bekannter Weise zu Drähten weiterverarbeitet wird.

6. Verfahren nach Anspruch 3, dadurch gekennzeichnet, daß vorgefertigte Drähte mit dem Legierungszusatz aus der Gruppe zum Cu- oder Bronze-Anteil elektrolytisch, mechanisch oder durch chemische Transportreaktion beschichtet werden bis zu einer Dicke von ca. 15 μm.

7. Verfahren nach Anspruch 3, dadurch gekennzeichnet, daß der Legierungszusatz aus der Gruppe II zu der Cu-Nb-Schmelze, zu den Nb-Drähten oder zum Nb-Pulver vor der mechanischen Verarbeitung zugegeben wird.

**Claims**

1. Superconductive bronze-Nb₃Sn wires containing alloying additives which stabilize the cubic phase in the superconductor, substantially prevent the formation of a tetragonal phase and/or reduce tetragonal deformation (1-c/a), said wires being prepared from a niobium component and a bronze component and being usable at high magnetic field values (> 10 T), comprising

   a) at least one alloying element from the group of ferromagnetic elements iron and nickel which is alloyed to at least one of the two components.

   b) at least one alloying element from the group I comprising Li, Sc, U, Ti, Zr, Hf, V, Ta, Mo, Re, Ru, Pd, Zn, Al, Ga, In, Tl, Si, Ge, Sb which is alloyed to at least one of the two components,

   c) when said alloying elements are alloyed to the niobium component, the total amount of alloyed elements from (a) and (b) in a weight percent range between 0.01 and 7, related to the niobium portion in the wire and/or

   d) when alloyed to the bronze component, the total amount of alloyed elements from (a) and (b) in a weight percent range between 0.05 and 10, related to the bronze portion in the wire.

2. Superconductive wires according to claim 1, wherein combinations alloyed to the Nb component consist of at least one ferromagnetic element of Fe and Ni, Fe being used in a weight percent range between 0.05 and 0.5 and Ni between 0.1 and 0.5, related to the Nb portion in the wire and consisting of at least one element of group II below in the weight percent ranges stated

| | |
|---|---|
| Ti 1 up to 5 wt.% | Mo 0.1 up to 0.5 wt.% |
| Zr 1 up to 5 wt.% | Re 0.1 up to 2 wt.% |
| Hf 1 up to 5 wt.% | Ru 0.1 up to 3 wt.% |
| V 1 up to 5 wt.% | Sc 0.01 up to 0.2 wt.% |
| Ta 1 up to 7 wt.% | Si 0.1 up to 1.5 wt.% |
| Pd 0.1 up to 2 wt.% | |
| U 1 up to 5 wt.% | |

related to the niobium portion in the wire and/or by alloying elements to the Cu or bronze components consisting of a least one element of the group below in the weight percent ranges stated

| | |
|---|---|
| Zn 0.1 up to 10 wt.% | Li 0.1 up to 1 wt.% |
| Al 0.1 up to 3 wt.% | In 0.1 up to 5 wt.% |
| Ga 0.1 up to 10 wt.% | Tl 0.05 up to 1 wt.% |
| Si 0.1 up to 3 wt.% | Sb 0.1 up to 5 wt.% |
| Ge 0.1 up to 0.5 wt.% | |

related to the Cu or bronze position in the wire.

3. Method for producing superconductive wires as defined in claim 1 on the basis of the bronze technique, the Cu matrix technique, the « in situ » technique or the powder metallurgical method wherein, in order to stabilize the cubic phase in the bronze-Nb₃Sn wire and to substantially reduce the formation of the tetragonal phase and/or to reduce the tetragonal deformation of the latter phase at low temperatures, even for high magnetic field values, an alloy is added to the niobium wires or to the niobium powder which consists of at least one ferromagnetic element of Fe and Ni in quantities equivalent to

   Fe 0.05 wt.% up to 0.5 wt.%,
   Ni 0.1 wt.% up to 0.5 wt.%, and

addition of at least one element from the group below, in quantities equivalent to

| | |
|---|---|
| Ti 1 up to 5 wt.% | Mo 0.1 up to 0.5 wt.% |
| Zr 1 up to 5 wt.% | Re 0.1 up to 2.0 wt.% |
| Hf 1 up to 5 wt.% | Ru 0.1 up to 3 wt.% |
| V 1 up to 5 wt.% | Sc 0.01 up to 0.2 wt.% |
| Ta 1 up to 7 wt.% | Si 0.1 up to 1.5 wt.% |
| Pd 0.1 up to 2 wt.% | |
| U 1 up to 5 wt.% | |

and/or an alloy is added to the copper or bronze portion which consists of at least one element of the group below, in quantities equivalent to

| | |
|---|---|
| Zn 0.1 up to 10 wt.% | Li 0.1 up to 1 wt.% |
| Al 0.1 up to 3 wt.% | In 0.1 up to 5 wt.% |
| Ga 0.1 up to 10 wt.% | Tl 0.05 up to 1 wt.% |
| Si 0.1 up to 3 wt.% | Sb 0.1 up to 5 wt.% |
| Ge 0.1 up to 0.5 wt.% | |

**0 048 313**

4. Method as defined in claim 3 wherein the superconductive Nb₃Sn wires after reaction are exposed to a neutron irradiation at temperatures between 4.2 K and 300 K (up to $2 \times 10^{18}$ n/cm² ; $E > 1$ MeV) in order to stabilize the cubic phase in the bronze-Nb₃Sn wire and to substantially prevent the formation of the tetragonal phase and/or to reduce the tetragonal deformation of the latter phase at low temperatures.

5. Method as defined in claim 3 wherein the alloying additive from the group is added to the Cu or bronze portion prior to melting and mixing, respectively, of the product constituents and the molten product or the mixture is processed into wires in a familar way.

6. Method as defined in claim 3 wherein prefabricated wires with the alloy added from the group to the Cu or bronze portion are coated electrolytically, mechanically or by chemical transport reaction up to a thickness of about 15 μm.

7. Method as defined in claim 3 wherein the alloying additive from group II is added to the Cu-Nb melt, the Nb wires or the Nb powder prior to mechanical processing.

**Revendications**

1. Fils de Nb₃Sn-bronze supraconducteurs avec des additions d'alliage qui stabilisent la phase cubique dans le supraconducteur, empêchent dans une large mesure la formation d'une phase tétragonale et/ou réduisent la déformation tétragonale (1-c/a) et qui sont utilisables en présence de valeurs élevées de champ magnétique (> 10 T), fabriqués à partir d'un composant de niobium et d'un composant de bronze, caractérisés par :

a) au moins un élément d'addition du groupe des éléments ferromagnétiques fer et nickel, allié à l'un au moins des deux composants,

b) au moins un élément d'addition du groupe I, Li, Sc, U, Ti, Zr, Hf, V, Ta, Mo, Re, Ru, Pd, Zn, Al, Ga, In, Tl, Si, Ge, Sb, allié à l'un au moins des composants,

c) dans le cas d'alliage au composant Nb, par la quantité totale des éléments d'addition de a) et de b) en pourcentage en poids compris entre 0,01 et 7, rapporté à la partie Nb existante dans le fil et/ou

d) dans le cas d'alliage au composant bronze, par la quantité totale des éléments d'addition de a) et de b) en pourcentage en poids compris entre 0,05 et 10, rapporté à la partie bronze existante dans le fil.

2. Fils supraconducteurs selon la revendication 1, caractérisés par des combinaisons d'alliage au composant Nb constituées d'au moins un élément ferromagnétique choisi entre Fe et Ni, dans lesquelles on utilise Fe dans des pourcentages compris entre 0,05 % en poids et 0,5 % en poids et Ni en pourcentages compris entre 0,1 % en poids et 0,5 % en poids, rapportés à la partie Nb dans le fil, et d'au moins, un élément du groupe II suivant, dans les pourcentages indiqués :

Ti de 1 à 5 % en poids          Mo de 0,1 à 0,5 % en poids
Zr de 1 à 5 % en poids          Re de 0,1 à 2 % en poids
Hf de 1 à 5 % en poids          Ru de 0,1 à 3 % en poids
V de 1 à 5 % en poids           Sc de 0,01 à 0,2 % en poids
Ta de 1 à 7 % en poids          Si de 0,1 à 1,5 % en poids
Pd de 0,1 à 2 % en poids
U de 1 à 5 % en poids

rapportés à la partie niobium dans le fil et/ou par des alliages supplémentaires aux composants Cu ou bronze constitués au moins d'un élément du groupe suivant, dans les pourcentages indiqués :

Zn de 0,1 à 10 % en poids       Li de 0,1 à 1 % en poids
Al de 0,1 à 3 % en poids        In de 0,1 à 5 % en poids
Ga de 0,1 à 10 % en poids       Tl de 0,05 à 1 % en poids
Si de 0,1 à 3 % en poids        Sb de 0,1 à 5 % en poids
Ge de 0,1 à 0,5 % en poids

rapportés aux parties Cu ou bronze dans le fil.

3. Procédé pour la fabrication de fils supraconducteurs désignés par la revendication 1, basé sur la technique au bronze, la technique du réseau de Cu, la technique « in situ » ou la méthode par la métallurgie des poudres, caractérisé en ce que, pour la stabilisation de la phase cubique dans le fil de Nb₃Sn-bronze et pour empêcher dans une large mesure la formation de la phase tétragonale et/ou pour la réduction de la déformation tétragonale elle-même aux basses températures, même en présence de valeurs élevées du champ magnétique, on ajoute au fil de niobium ou à la poudre de niobium une addition d'alliage d'au moins un élément ferromagnétique choisi entre Fe et Ni en quantités correspondant à :

Fe de 0,05 % en poids à 0,5 % en poids
Ni de 0,1 % en poids à 0,5 % en poids

et d'au moins un élément du groupe suivant dans les quantités correspondant à :

7

Ti de 1 à 5 % en poids
Zr de 1 à 5 % en poids
Hf de 1 à 5 % en poids
V de 1 à 5 % en poids
Ta de 1 à 7 % en poids
Pd de 0,1 à 2 % en poids
U de 1 à 5 % en poids

Mo de 0,1 à 0,5 % en poids
Re de 0,1 à 2,0 % en poids
Ru de 0,1 à 3 % en poids
Sc de 0,01 à 0,2 % en poids
Si de 0,1 à 1,5 % en poids

et/ou aux parties cuivre ou bronze, une addition d'alliage d'au moins un élément du groupe suivant en quantités correspondant à :

Zn de 0,1 à 10 % en poids
Al de 0,1 à 3 % en poids
Ga de 0,1 à 10 % en poids
Si de 0,1 à 3 % en poids
Ge de 0,1 à 0,5 % en poids

Li de 0,1 à 1 % en poids
In de 0,1 à 5 % en poids
Tl de 0,05 à 1 % en poids
Sb de 0,1 à 5 % en poids

4. Procédé selon la revendication 3, caractérisé en ce que l'on expose après la réaction les fils supraconducteurs de $Nb_3Sn$ à une irradiation par des neutrons à des températures comprises entre 4,2 K et 300 K (jusqu'à $2 \cdot 10^{18}$ n/cm² ; E > 1 MeV) pour stabiliser la phase cubique dans le fil de $Nb_3Sn$-bronze et pour empêcher dans une large mesure la formation de la phase tétragonale et/ou pour réduire la déformation tétragonale elle-même aux basses températures.

5. Procédé selon la revendication 3, caractérisé en ce que l'on procède à l'addition d'alliage du groupe allié aux parties Cu ou bronze avant la fusion ou avant le mélange des parties constituantes du produit et qu'après cela, le produit de la fusion ou le mélange sont transformés en fil suivant la façon connue.

6. Procédé selon la revendication 3, caractérisé par le fait que des fils déjà préparés sont revêtus avec l'additif du groupe prévu pour la partie Cu ou la partie bronze électrolytiquement, mécaniquement ou par réaction chimique de transport, jusqu'à une épaisseur d'environ 15 μ.

7. Procédé selon la revendication 3, caractérisé en ce que l'addition d'alliage du groupe II à la masse fondue de Cu-Nb, au fil de Nb, ou à la poudre de Nb est effectuée avant la transformation mécanique.